# EUROPÄISCHE PATENTSCHRIFT

(11) **EP 3 546 966 B1**
(45) Veröffentlichungstag und Bekanntmachung des Hinweises auf die Patenterteilung: **23.12.2020**
(21) Anmeldenummer: 19165090.2
(22) Anmeldetag: 26.03.2019
(51) Int. Cl.: G01R 33/30, G01R 33/62

(54) **NMR-MAS-PROBENKOPF MIT OPTIMIERTEM MAS-DNP-SPULENKLOTZ FÜR SCHNELLE PROBENROTATION**
NMR-MAS SAMPLING HEAD WITH OPTIMISED MAS-DNP COIL BLOCK FOR FAST SAMPLE ROTATION
TÊTE D'ÉCHANTILLON MAS RMN POURVU DE BLOC BOBINE MAS DNP OPTIMISÉ DESTINÉ À LA ROTATION D'ÉCHANTILLON RAPIDE

(30) Priorität: 29.03.2018 DE 102018204913
(43) Veröffentlichungstag der Anmeldung: 02.10.2019
(73) Patentinhaber: Bruker BioSpin GmbH, 76287 Rheinstetten (DE)
(72) Erfinder: Purea, Armin, 76669 Bad Schönborn (DE); Reiter, Christian, 77646 Bruchsal (DE); Dimitriadis, I. Alexandros, 1260 Nyon (CH)
(74) Vertreter: Kohler Schmid Möbus Patentanwälte

(56) Entgegenhaltungen:
- DE-B3-102016 207 998
- ROSAY MELANIE ET AL: "Instrumentation for solid-state dynamic nuclear polarization with magic angle spinning NMR", JOURNAL OF MAGNETIC RESONANCE, ACADEMIC PRESS, ORLANDO, FL, US, Bd. 264, 23. Februar 2016 (2016-02-23), Seiten 88-98, XP029432493, ISSN: 1090-7807, DOI: 10.1016/J.JMR.2015.12.026
- ALEXANDER B. BARNES ET AL: "Dynamic nuclear polarization at 700MHz/460GHz", JOURNAL OF MAGNETIC RESONANCE., Bd. 224, 14. August 2012 (2012-08-14), Seiten 1-7, XP055606367, US ISSN: 1090-7807, DOI: 10.1016/j.jmr.2012.08.002
- SERGEYEV IVAN V ET AL: "Efficient 263 GHz magic angle spinning DNP at 100 K using solid-state diode sources", SOLID STATE NUCLEAR MAGNETIC RESONANCE, Bd. 100, 28. März 2019 (2019-03-28), Seiten 63-69, XP085684324, ISSN: 0926-2040, DOI: 10.1016/J.SSNMR.2019.03.008

## Beschreibung

Die Erfindung betrifft einen NMR-MAS-Probenkopf mit einem MAS-Stator zur Aufnahme eines länglichen, von einer HF-Spule umgebenen MAS-Rotors mit einer Probensubstanz in einem Probenvolumen, und mit einem hohlen, länglichen ersten Mikrowellenleiter zur Zuführung von Mikrowellenstrahlung durch einen in eine Wand des MAS-Stators eingeführten Spulenklotz hindurch in das Probenvolumen, sowie einen entsprechenden Spulenklotz.

Ein solcher NMR-MAS-Probenkopf sowie der zugehörige Spulenklotz sind bekannt aus dem Patent DE 10 2016 207 998 B3 (= Referenz [1]).

### Hintergrund der Erfindung

Die vorliegende Erfindung betrifft allgemein den Bereich der Magnetresonanz (MR). Kernspinresonanz(NMR)-Spektroskopie ist eine kommerziell weit verbreitete Methode der MR zur Charakterisierung der chemischen Zusammensetzung von Substanzen. Generell werden bei der MR Hochfrequenz(=HF)-Pulse in die Messprobe, die sich in einem starken statischen Magnetfeld befindet, eingestrahlt, und die elektromagnetische Reaktion der Probe wird vermessen. Bei der Festkörper NMR-Spektroskopie ist es weiter bekannt, zur Verringerung von Linienverbreiterungen aufgrund anisotroper Wechselwirkungen eine NMR-Probe während der spektroskopischen Vermessung unter dem so genannten "Magischen Winkel" von ca. 54,74° gegenüber dem statischen Magnetfeld verkippt rotieren zu lassen ("MAS" = Magic Angle Spinning). Dazu wird die Probe in einen MAS-Rotor gefüllt. MAS-Rotoren sind zylindrische Röhrchen, die mit einer oder zwei Kappen verschlossen sind, wobei die obere mit Flügelelementen («Schaufelrädchen») versehen ist. Der MAS-Rotor wird in einem MAS-Stator angeordnet, und mit Gasdruck wird der MAS-Rotor über die Flügelelemente für die Rotation angetrieben. Die Gesamtheit aus MAS-Rotor und MAS-Stator wird MAS-Turbine genannt.

Während der NMR-Messung ist die MAS-Turbine in einem NMR-MAS-Probenkopf angeordnet. Der Probenkopf verfügt über ein zylindrisches Abschirmrohr. Darin sind HF-Elektronikbauteile, insbesondere HF- Spulen, und die MAS-Turbine untergebracht. Der Probenkopf wird mit seinem Abschirmrohr typischerweise von unten in die vertikale Raumtemperaturbohrung eines supraleitenden Magneten eingeführt, positioniert, und mit Haken, Stützen, Schrauben oder dergleichen gehalten. Die MAS-Turbine befindet sich dann genau im magnetischen Zentrum des Magneten.

Zusätzlich zur Festkörper-NMR kann auch die Technik des dynamischen Transfers der Spin-Polarisation (DNP= Dynamic Nuclear Polarization) eingesetzt werden. Die DNP-Technik erfordert die gleichzeitige Einstrahlung eines magnetischen Mikrowellenfeldes auf einer Frequenz, die etwa um den Faktor 660 höher als die Larmor-Frequenz der 1H Kerne ist. Durch Einstrahlung eines Mikrowellenfeldes in geeigneter Frequenz werden Elektronenspins angeregt, wonach aufgrund von Spin-Wechselwirkungen ein Transfer der Elektronenpolarisation auf die Atomkerne der Probe bewirkt werden kann.

Die Einstrahlung der Mikrowelle bei DNP-Probenköpfen geschieht aktuell im Stand der Technik, indem die Öffnung eines geriffelten Wellenleiters (Double Miter Bend) auf den MAS-Rotor gerichtet wird. Dieser Ansatz ist zwar technisch einfach umsetzbar, jedoch wird nur ein Bruchteil der eingesetzten Leistung genutzt. Grund hierfür sind unerwünschte Reflexionen, Beugungen etc. Darüber hinaus wird bei Systemen mit Rotor-Durchmessern von (genauer: knapp unterhalb von) 1,3mm eine HF-Spule benutzt, die im Vergleich zu nicht-DNP-Probenköpfen weniger effizient ist, da sie sonst kaum noch mikrowellendurchlässig wäre.

In der eingangs zitierten Referenz [1], dem Vorgängerprojekt zur vorliegenden Erfindung, wurde von der Anmelderin eine Optimierung entwickelt, die u.a. mit Hilfe einer Linse und eines Spiegels das Mikrowellen-Magnetfeld im DNP-Stator mit einer Rotorbohrung von 3,2mm ungefähr verdoppelt, was die Leistung für gleiches Feld um Faktor 4 verringert.

Betrachtet man kleinere MAS-Durchmesser, dann lässt sich einfach abschätzen, dass eine Fokussierung auf einen kleineren Querschnitt zu einer deutlichen Felderhöhung führen müsste, für einen Querschnitt des MAS-Rotors von ca. 1,9mm liegt die Leistungseinsparung bei etwa einem Faktor 5, für einen Rotordurchmesser von ca. 1,3mm bei etwa 20.

### Spezieller Stand der Technik

Derzeit erfolgt bei den meisten Systemen nach dem Stand der Technik üblicherweise eine simple Mikrowellen-Einstrahlung in den MAS-Stator durch ein rundes Loch im Spulenklotz durch die HF-Spule, gegebenenfalls mit einer geeigneten Aufweitung der Spulenwindungen im Zentrum ohne weitere Maßnahmen. Dadurch gelangt jedoch nur ein Bruchteil der eingebrachten Leistung ins magnetische Wechselfeld am Ort der Probe.

In dem Zeitschriftenartikel Cryogenic sample exchange NMR probe for magic angle spinning dynamic nuclear polarization, A. Barnes et al., Journal of Magnetic Resonance 198 (2009) 261-270 (=Reference [2]) wird ein 4mm-Probenkopf gezeigt, dessen Statorwände metallisiert sind. Es fehlt jedoch eine Linse. Außerdem stellt sich hier nicht das Problem der Fokussierung auf einen kleinen Rotor, da der Wellenleiter ähnliche Abmessungen hat wie der Rotor.

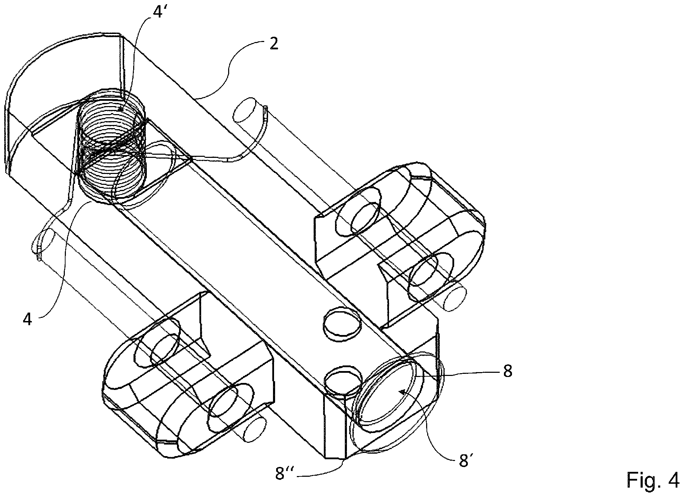

Die WO 2015/175507 A1 (= Referenz [3]) beschreibt bereits eine Anordnung mit einigen, wenngleich nicht sämtlichen der eingangs definierten Merkmale. Gezeigt werden mehrere Methoden zur Einstrahlung. In einer Variante (dortige Fig. 4F) wird eine HF-Spule mit Lücke gewickelt, hinter der Spule befindet sich ein gekrümmter Spiegel. Innerhalb des Rotors befindet sich eine weitere Spule, die induktiv angekoppelt wird und damit höhere HF-Effizienz besitzt. Auch innerhalb des Rotors befinden sich Spiegel. Obwohl hier eine kleine HF-Spule verwendet wird, ist man in der Drehzahl begrenzt aufgrund des Rotordurchmessers. In Fig. 10A wird eine Variante mit Teflon-Linse am Wellenleiter-Ausgang gezeigt, die mit einem verstellbaren Spiegel einen Resonator bildet. Die in Fig. 10C gezeigte Feldverteilung impliziert, dass die bekannte Anordnung einen abstimmbaren Resonator erzeugt. Der dort gezeigte verstellbare Spiegel soll eine "cavity mode" abstimmen. Weiterhin sieht man in Fig. 10C der Druckschrift, dass die Wellenlänge etwa dem doppelten Rotordurchmesser entspricht. Das bedeutet für ein 3,2mm-System eine Vakuumwellenlänge von etwa 6mm und damit eine Frequenz von 50GHz.. Während solch eine stark resonante Struktur den Vorteil hoher Feldamplitude besitzt, liegt ein grundsätzlicher Nachteil von derartigen Resonatoren darin, dass die üblicherweise hohe erzielbare Güte eine sehr schmale

Frequenzbandbreite bedingt, die sehr empfindlich auf äußere oder innere Einflüsse reagiert und somit eine sehr präzise Abstimmung erfordert.

Die US 2016/0334476 A1 (= Referenz [4]) zeigt einen Resonator für *nicht-MAS-*DNP-Anwendungen, der innerhalb der HF-Spule aufgebaut und vom Wellenleiter über ein Dielektrikum angekoppelt wird. Dieser Resonator wird so konstruiert, dass er für HF-Strahlung durchsichtig, für Mikrowellen hingegen undurchsichtig ist. Die mikrowellenrelevanten Komponenten bei diesem bekannten System sind -zumindest größtenteils- innerhalb der HF-Spule angeordnet. Die Mikrowelleneffizienz ist daher nicht sonderlich hoch.

Die EP 3 030 917 B1 (= Referenz [5]) zeigt einen dielektrischen Koppler, mit dem Mikrowellenleistung aus dem Wellenleiter effektiver zum Rotor gebracht werden soll. Die Einflüsse der HF-Spule auf die Mikrowellenleistung werden allerdings nicht berücksichtigt.

Die US 2017/0074952 A1 (= Referenz [6]) bezieht sich auf Systeme und Verfahren zur Probenahme von Fluiden aus Öl- und Gasbohrlöchern unter Verwendung von kernmagnetischer Resonanz (immerhin also auch NMR). Das Leitungssystem enthält integrale Spulen zum Übertragen einer NMR-Impulssequenz und Detektieren von NMR-Signalen. Die HF Solenoidspule ist auf einen zylindrischen Träger gewickelt, optional in einer Nut geführt, und anschließend in einen zweiten Zylinder geschoben. Dadurch ist die Spule mechanisch gesichert von der Probe getrennt, die innen sowie außen vorbeiläuft. Benötigt man einen inneren Spulenträger, sinkt der Füllfaktor. Bei Festkörper-NMR und insbesondere bei MAS ist die Probenpositionierung daher in der Regel auf das Innere des Solenoids beschränkt.

Die eingangs zitierte Referenz [1] hingegen beschreibt bereits eine vollständige gattungsgemäße Anordnung mit sämtlichen eingangs definierten Merkmalen. Hier werden eine Linse und ein Spiegel verwendet, um den einfallenden Strahl so zu verändern, dass immer ein senkrechter Einfall auf den Rotor erfolgt. Die Dicke der Rotorwand sowie der Windungsabstand der Spule wurden damit ebenfalls optimiert. Die Anordnung nach Referenz [1] zielt jedoch insbesondere auf die Verbesserung des aktuellen 3,2mm-Systems ab. Bei kleineren Rotoren-Durchmessern hingegen halten sich die Vorteile in Grenzen.

### Aufgabe der Erfindung

Der vorliegenden Erfindung liegt demgegenüber die Aufgabe zugrunde, einen Spulenklotz für einen NMR-MAS-Probenkopf der eingangs definierten Art zur Verfügung zu stellen, der eine weitere wesentliche Verbesserung der Effizienz der Mikrowelleneinstrahlung, also der magnetischen Feldstärke pro eingestrahlter Leistungseinheit, insbesondere auch bei kleineren als den derzeit üblichen 3,2mm-Systemen, ermöglicht und zwar idealerweise in dem Maße, dass herkömmliche, teure Mikrowellenquellen durch kleinere, billigere Quellen ersetzbar werden. Gleichzeitig soll mit der vorliegenden Erfindung auch die Induktivität der HF-Spule beibehalten und die HF-Effizienz verbessert werden.

### Kurze Beschreibung der Erfindung

Diese Aufgabe wird gelöst durch einen NMR-MAS-Probenkopf der eingangs genannten Art sowie durch einen erfindungsgemäß modifizierten Spulenklotz. Der erfindungsgemässe Spulenklotz zur Verwendung in einem NMR-MAS-Probenkopf mit einem ersten Mikrowellenleiter ist aus einem elektrisch nicht-leitenden dielektrischen Material aufgebaut und weist eine erste Bohrung auf, welche dazu eingerichtet ist, im Betriebszustand des NMR-MAS-Probenkopfes einen MAS-Rotor aufzunehmen, koaxial zum Rotor verlaufend. Die erste Bohrung weist eine innere Wandung auf, an der eine HF-Spule zur Durchführung von NMR-Messungen an einer Probensubstanz, welche sich im Rotor des NMR-MAS-Probenkopfes befindet, befestigt ist. Ausserdem weist der Spulenklotz eine zweite Bohrung auf, die einen hohlen, länglichen zweiten Mikrowellenleiter umfasst, zur Weiterleitung von Mikrowellen aus dem ersten Mikrowellenleiter des NMR-MAS-Probenkopfes, und welche geometrisch so ausgebildet ist, dass sie koaxial zu einer Längsachse des ersten Mikrowellenleiters angeordnet werden kann.

Der erfindungsgemässe NMR-MAS-Probenkopf der eingangs genannten Art weist einen derartigen Spulenklotz auf, wobei der Spulenklotz geometrisch so ausgedehnt und in die Wand des MAS-Stators derart eingeführt ist, dass er die HF-Spule und den MAS-Rotor zumindest teilweise umgibt.

Vorzugsweise kann die HF-Spule auch vollständig den MAS-Rotor umgeben. Die Befestigung der HF-Spule an der inneren Wandung der ersten Bohrung kann kraftschlüssig, formschlüssig in einer Nut oder auch stoffschlüssig, etwa mittels Klebstoff, erfolgen. Bevorzugt ist eine kraftschlüssige Verbindung.

Mit der vorliegenden Erfindung wird ein Probenkopf für die NMR-DNP-MAS-Spektroskopie bereitgestellt, der eine noch bessere Ausbeute der einfallenden Mikrowellenleistung insbesondere auch bei Systemen mit Rotor-Durchmessern von deutlich weniger als 3,2mm ermöglicht, indem mehrere -jeweils an sich bekannte- Komponenten erfindungsgemäß kombiniert werden.

Theoretisch wäre eine solche Erhöhung der effektiv wirksamen Mikrowellenleistung auch möglich, indem eine Linse (wie in Referenz [1] vorgeschlagen) den aus dem ersten Wellenleiter kommenden MikrowellenStrahl auf den MAS-Rotor fokussiert. In der praktischen Umsetzung scheitert dies jedoch an den geringen Abmessungen des Stators im Vergleich zum Ausgang des ersten Wellenleiters. Entweder müsste der MAS-Stator für den gebündelten Strahl geöffnet werden, was sich nicht mit der MAS-Funktion vereinbaren lässt, oder der Wellenleiter müsste näher an den MAS-Rotor gebracht werden. Mit dem bestehenden Durchmesser ist letzteres jedoch auch nicht durchführbar aufgrund der geringen Höhe eines 1,3mm-Stators. Daher wird erfindungsgemäß ein kleinerer zweiter Waveguide in Form eines metallischen Rohrs oder einer metallisierten Bohrung eingesetzt, der in den Spulenklotz eingebracht ist und für die Leitung der Mikrowellenstrahlung innerhalb des MAS-Stators verantwortlich ist.

Im Spulenklotz endet der Wellenleiter mit ausreichendem Abstand vor der HF-Spule, um Störeinflüsse aus die NMR-Messung zu reduzieren. Die Rückseite des Spulenklotzes ist metallisch beschichtet oder mit einer Metallfolie beklebt und kann dann schon als Spiegel wirken. Simulationen zeigen, dass sich dadurch eine Steigerung der Feldeffizienz von ca. 4 erreichen lässt, was einer Leistungseinsparung von 4²=16 entspricht. Zum Vergleich: Beim der Anordnung nach Referenz [1] lag die Leistungseinsparung nur bei ca. 3-4.

### Weitere Vorteile gegenüber dem Stand der Technik:

Ein entscheidender Vorteil der erfindungsgemäßen Merkmalskombination liegt auch darin, dass MAS-Spulen für DNP ermöglicht werden, die sowohl für die Mikrowellenstrahlung als auch für die HF-Strahlung gut dimensioniert sind. Herkömmlich kommt eine freitragende HF-Spule (mit verbackenem Lack) zum Einsatz, die dann aber eng und aus dickerem Draht (∼0,2mm) gewickelt werden muss, sonst fehlt es an er notwendigen Festigkeit. Nimmt man zu viele Windungen liegen die Windungen dicht aneinander und es wird keine Mikrowelle mehr transmittiert. Vorteilhaft wäre daher eine Spule mit vielen Windungen aber dennoch Abstand zwischen den Windungen. Dies lässt sich aber nur durch dünnen Draht (∼0,1 mm) erreichen, welcher dann freilich nicht mehr genug Steifigkeit für die HF-Spule besitzt. Mit dem erfindungsgemäß modifizierten Spulenblock hingegen wird die HF-Spule jedoch innerhalb einer Bohrung festgehalten, wodurch sie mechanisch immobilisiert wird. Eine Fixierung der HF-Spule kann z.B. durch Nuten im Spulenklotzkörper erfolgen, in denen der Leiter festgeklebt wird.

Ein weiterer Vorteil der vorliegenden Erfindung liegt schließlich auch darin, dass der vorhandene, marktübliche MAS-Stator kaum modifiziert werden muss und die Zusatzteile nur einen sehr geringen einen Materialaufwand erfordern, so dass die erfindungsgemäße Lehre äußerst kostengünstig verwirklicht werden kann. Die von der erfindungsgemäßen Lehre vorgeschriebenen Änderungen sind kompakt in einem Bauteil vereint, das sich leicht austauschen lässt. Ein großer Vorteil darin ist die Einfachheit, denn am herkömmlichen MAS-Stator sind überhaupt keine Änderungen notwendig. Für den Umbau eines üblichen 1,3mm-Probenkopfes muss lediglich der Spulenklotz getauscht und gegebenenfalls eine Linse in den Wellenleiterausgang eingebracht werden.

### Bevorzugte Ausführungsformen und Weiterbildungen der Erfindung

Bei besonders bevorzugten Ausführungsformen des erfindungsgemäßen MAS-NMR-Probenkopfs ist die erste Bohrung des Spulenklotzes zur Aufnahme eines MAS-Rotors mit einem Durchmesser kleiner als 2mm, vorzugsweise einem Durchmesser von 0,4mm bis 1,9mm, insbesondere einem Durchmesser von etwa 1,3mm, dimensioniert. Die geringen Abmessungen derart kleiner Rotoren erlauben eine bedeutende Erhöhung der Effizienz, da der Eingangsquerschnitt des ersten Waveguides konstant bleibt.

Des Weiteren erweisen sich Ausführungsformen der Erfindung als besonders nützlich, bei welchen der erste Mikrowellenleiter geometrisch, insbesondere hinsichtlich seines Durchmessers und seiner Form, derart aufgebaut ist, dass er die durch ihn geleitete Mikrowellenstrahlung auf die ihm zugewandte Öffnung des zweiten Mikrowellenleiters im Spulenklotz fokussiert. Damit kann eine konzentrierte Hinleitung der Mikrowellenleistung auf das Probenvolumen sichergestellt werden.

Besonders vorteilhaft ist eine dazu alternative Klasse von Ausführungsformen, bei welchen zwischen dem ersten Mikrowellenleiter und dem Spulenklotz, vorzugsweise an dem Spulenklotzseitigen freien Ende des ersten Mikrowellenleiters, eine Mikrowellenlinse zur Bündelung der zugeführten Mikrowellenstrahlung auf die Linsenseitige Öffnung des zweiten Mikrowellenleiters angeordnet ist. Dadurch wird ein noch größerer Anteil der verfügbaren Mikrowellenleistung vom ersten Wellenleiter in den zweiten Wellenleiter eingekoppelt.

Besonders bevorzugt sind Weiterbildungen dieser Klasse von Ausführungsformen des erfindungsgemäßen NMR-MAS-Probenkopfes, die sich dadurch auszeichnen, dass die Mikrowellenlinse auf der dem Probenvolumen zugewandten Seite derart angeordnet und hinsichtlich ihrer Brennweite geometrisch so ausgebildet ist, dass die Linsenseitige Öffnung des zweiten Mikrowellenleiters im Brennpunkt der Mikrowellenlinse liegt. Dadurch wird ein maximaler Anteil der verfügbaren Mikrowellenleistung vom ersten Wellenleiter in den zweiten Wellenleiter eingekoppelt.

In der Praxis ist bei bevorzugten Weiterbildungen der oben definierten Klasse von Ausführungsformen die Mikrowellenlinse aus dielektrischem Material, vorzugsweise aus PTFE, in Spezialanwendungen eventuell auch aus Saphir und/oder Silizium und/oder Bornitrid, aufgebaut. Diese Materialien bewirken nur geringe Verluste (tan d ≤ 0,001) sowie eine hohe Brechkraft auch für dünne Linsen.

Auf den äußeren Oberflächen der Mikrowellenlinse kann eine Anti-Reflexionsschicht, vorzugsweise aus Kunststoff, insbesondere aus PTFE oder Vespel, oder aus einer sub-Wellenlängen-Struktur, aufgebracht sein. Eine solche Antireflexschicht maximiert die Transmission des einfallenden Strahls durch die Linse.

Die Mikrowellenlinse kann in Strahlungsrichtung der aus dem zweiten Mikrowellenleiter in Richtung auf das Probenvolumen austretenden Mikrowellenstrahlung gesehen konvex-plan ausgeführt sein und insbesondere auf ihrer Mittelachse eine Dicke zwischen 1mm und 5mm, vorzugsweise etwa 4mm, aufweisen. Außerdem wird die Mikrowellenlinse in der Praxis mindestens eine sphärische oder zylindrische Fläche, insbesondere mit einem Krümmungsradius zwischen 3mm und 10mm, vorzugsweise etwa 4mm, aufweisen.

Statt einer Linse auf dem Ausgang des ersten Wellenleiters kann auch eine Querschnittsreduktion zum Ausgang des ersten Wellenleiters vorgenommen werden (sogenannter "Taper"), um den Mikrowellenstrahl effizient in den zweiten Wellenleiter zu übertragen.

Bei einer weiteren Klasse von vorteilhaften Ausführungsformen des erfindungsgemäßen NMR-MAS-Probenkopfes ist auf der dem zweiten Mikrowellenleiter bezüglich des MAS-Rotors gegenüberliegenden Innenseite des MAS-Stators ein Mikrowellenspiegel zur Reflexion der aus dem zweiten Mikrowellenleiter austretenden und durch das Probenvolumen hindurchtretenden Mikrowellenstrahlung vorhanden. Die aus dem Probenvolumen und MAS-Rotor wieder austretende Mikrowelle wird erneut auf das Probenvolumen reflektiert, wodurch ein noch höherer Anteil genutzt werden kann.

Der Mikrowellenspiegel wird in der Regel eine metallische oder metallisierte Schicht umfassen, insbesondere aus Ag, Au oder Cu-Blech, welches vorzugsweise eine Dicke zwischen 0,1µm und 100µm, bevorzugt etwa 1µm, aufweist. Dünnes Blech aus den genannten Materialien minimiert die statische und HF-Feldverzerrung, während die Mikrowellenstrahlung aufgrund der geringen Skintiefe vollständig reflektiert wird. Alternativ kann der Mikrowellenspiegel eine oder mehrere dielektrische Schichten umfassen.

Besonders bevorzugte Weiterbildungen der obigen Klasse von Ausführungsformen zeichnen sich dadurch aus, dass der Mikrowellenspiegel am Spulenklotz angebracht oder räumlich in den Spulenklotz integriert ist. Damit ergibt sich eine kompakte Bauform und der Spiegel muss nicht separat angebracht werden, etwa am MAS-Stator. Außerdem ist das Aufbringen außen am Spulenklotz einfacher als innen am MAS-Stator.

Andere Weiterbildungen sind dadurch gekennzeichnet, dass der Mikrowellenspiegel zylindrisch oder sphärisch sowie in Richtung auf das Probenvolumen konkav aufgebaut ist, und dass der Mikrowellenspiegel konstruktiv derart ausgestaltet ist, dass er die vom Probenvolumen kommend auf ihn auftreffende Mikrowellenstrahlung auf die Längsachse des MAS-Rotors fokussiert. Damit werden die oben genannten Vorteile dieser Klasse von Ausführungsformen noch weiter erhöht, insbesondere in Richtung einer noch höheren Effektivität bei der Ausnutzung der eingestrahlten Mikrowellenleistung.

Bei einer weiteren Klasse von bevorzugten Ausführungsformen des erfindungsgemäßen NMR-MAS-Probenkopfes ist die HF-Spule eine aus mehreren voneinander beabstandeten Windungen aufgebaute einlagige Solenoidspule, deren Windungsdrahtdicke d und Windungsabstand D so optimiert sind, dass die Mikrowellenstrahlung durch die HF-Spule zu mindestens 80% transmittiert wird. Die Spule stellt dann kein Hindernis mehr für die Mikrowellenstrahlung dar. Ansonsten würde nämlich ein großer Teil der eingebrachten Leistung wieder zurückreflektiert, bevor sie ins Probenvolumen gelangt.

Die erfindungsgemäßen Vorteile können besonders bei Weiterbildungen dieser Klasse von Ausführungsformen ausgenutzt werden, bei welchen das Verhältnis von d zu D gleich oder kleiner als 0,5 und das Verhältnis von D zur Wellenlänge der Mikrowellenstrahlung im Vakuum größer als 0,2 ist.

Bei MAS-Spulen für DNP-Anwendungen ist generell ein Kompromiss erforderlich zwischen einerseits der Induktivität der HF-Spule, die mit der Anzahl der Windungen korreliert und auf den verwendeten HF-Bereich optimiert werden sollte, und andererseits der Mikrowellentransparenz der HF-Spule, die einen Mindestabstand zwischen den Windungen erfordert. Zu niedrigen Frequenzen hin sollte die Induktivität erhöht werden während der Windungsabstand zur Gewährleistung adäquater Mikrowelleneinstrahlung vergrößert werden muss. Da die Spulenlänge hierbei von der Turbinengeometrie vorgegeben ist, führt das zu widersinnigen Anforderungen.

Günstige Parameter für die HF-Spule liegen in folgenden Wertebereichen vor: In der Praxis werden die HF-Spule zwischen 6 und 12 Windungen, eine Windungsdrahtdicke 0,05mm ≤ d ≤ 0,30mm, eine Spulenlänge von etwa 2,5mm sowie eine Steigung der Windungen zwischen 0,1mm und 1mm aufweisen. Dies sind typische Maße für 1,3mm-Systeme, die einerseits zu einer transparenten Spule im Mikrowellenbereich, jedoch andererseits auch zu einer effizienten Spule im HF-Bereich führen. Laut Gittertheorie (diese gilt strenggenommen nur für planare Gitter, nicht für gewundene Gitter wie Spulen) ist die Transmission dann noch >67% bei entsprechend günstiger Polarisation der einfallenden Welle.

Auch sollte die HF-Spule aus einem magnetisch kompensierten Draht oder aus Cu und/oder Ag und/oder Al oder deren Legierungen aufgebaut sein, wodurch eine Feldverzerrung des statischen Magnetfelds weitgehend reduziert wird.

Vorzugsweise besteht zwischen dem spulenzugewandten Ende des zweiten Mikrowellenleiters und der HF-Spule ein Abstand von 0,5mm bis 3mm. Damit führt der Wellenleiter die Mikrowellenstrahlung hinreichend nahe ans Probenvolumen, so dass eine gute Kopplung stattfindet. Gleichzeitig reicht der Abstand aber auch aus, um elektrische Durchschläge oder Feldverzerrungen des B1-Feldes zu vermeiden.

Mit dem erfingungsgemässen Spulenklotz, siehe Anspruch 11, sind die Änderungen gegenüber dem Stand der Technik kompakt in einem Bauteil vereint, mit dem sich leicht ein herkömmliches Bauteil im Austausch ersetzen lässt.

Vorzugsweise ist der erfindungsgemäße Spulenklotz aus einem dielektrischen Material aufgebaut, welches eine hohe mechanische Steifigkeit aufweist, keine Störungssignale im NMR-Betrieb erzeugt (wie dies etwa bei Polymeren der Fall wäre) und in einem breiten Temperaturbereich keine Ausdehnung oder Schrumpfung gegenüber dem MAS-Stator zulässt (BN ca. 3x10⁻⁶K⁻¹), vorzugsweise aus Keramik, Saphir oder Quarzglas. Dies sind unmagnetische, nicht-leitende, mechanisch stabile Materialien mit ausreichender Durchlässigkeit und geringer Dämpfung für die Mikrowellenstrahlung.

Die Vorteile der vorliegenden Erfindung kommen in besonders günstiger Weise bei Weiterbildungen zum Tragen, bei denen im erfindungsgemäßen Spulenklotz der Innendurchmesser des zweiten Mikrowellenleiters kleiner ist als der Innendurchmesser des ersten Mikrowellenleiters, vorzugsweise um mindestens 50%. Die Erfindung funktioniert umso besser, je kleiner der Rotor-Querschnitt ist, auf den fokussiert wird. Indirekt ergibt sich daraus auch die Größe des zweiten Wellenleiters. Nach unten begrenzt ist man durch die Wellenlänge: Wenn der Durchmesser zu gering wird im Verhältnis dazu, ergibt sich ein Cut-off.

Bevorzugt ist bei Weiterbildungen die bezüglich der HF-Spule dem zweiten Mikrowellenleiter gegenüberliegende Rückseite des Spulenklotzes derart metallisch beschichtet oder mit einer Metallfolie versehen, dass sie als Mikrowellenspiegel wirkt. Damit ergibt sich eine besonders kompakte Bauform. Der Spiegel muss nicht separat angebracht werden, z.B. am MAS-Stator. Außerdem ist das Aufbringen von außen am Spulenklotz einfacher als innen am MAS-Stator. Die aus dem Probenvolumen und dem MAS-Rotor wieder austretende Mikrowellenstrahlung wird erneut auf das Probenvolumen reflektiert, wodurch ein höherer Anteil genutzt werden kann.

In der Praxis bewähren sich in besonderer Weise auch Weiterbildungen des erfindungsgemäßen Spulenklotzes, bei welchen die zweite Bohrung eine metallische Beschichtung ihrer Innenwandung aufweist und dadurch als in den Spulenklotz integrierter zweiter Mikrowellenleiter wirkt. Dieser Ansatz erfordert weniger Materialstärke und kann vorteilhaft sein, wenn man nahe an der Cut-off-Abmessung liegt. Außerdem sind auf diese Weise potentiell weniger Störungen des statischen Magnetfelds zu erwarten, da man deutlich weniger Metall in Probennähe bringt. Der zweite Mikrowellenleiter kann vorteilhaft mit einer Riffelung (sogenannte "corrugations") ausgeführt werden. Das würde den HE11-Mode besser erhalten.

Andere bevorzugte Weiterbildungen des erfindungsgemäßen Spulenklotzes sind dadurch gekennzeichnet, dass die zweite Bohrung eine metallische Beschichtung ihrer Innenwandung aufweist und dadurch als in den Spulenklotz integrierter zweiter Mikrowellenleiter wirkt.

Die Innenwandung der ersten Bohrung kann bei Weiterbildungen eine Riffelung oder Nutenstruktur aufweisen, an welcher die HF-Spule kraft- und/oder formschlüssig befestigt ist. Auch eine Verklebung der HF-Spule ist möglich. Damit erhält man eine bessere Kontrolle über den Windungsabstand. Des Weiteren lassen sich damit HF-Spulen mit variablem Windungsabstand realisieren.

Schließlich kann bei Weiterbildungen des erfindungsgemäßen Spulenklotzes das Spulenabgewandte Ende des rohrförmigen zweiten Mikrowellenleiters eine, insbesondere trompetenartige, Aufweitung aufweisen, welche in speziellen Anwendungsfällen von Vorteil sein kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematische Querschnittsdarstellung einer ersten Ausführungsform des erfindungsgemäßen NMR-MAS-Probenkopfes;
- Fig. 2a: eine schematische Querschnittsdarstellung eines NMR-MAS-Probenkopfs gemäß der Erfindung mit einem die HF-Spule in einer Bohrung tragenden Spulenklotz sowie einem zweiten Mikrowellenleiter;
- Fig. 2b: eine schematische Querschnittsdarstellung eines NMR-MAS-Probenkopfs gemäß dem nächstkommenden Stand der Technik nach Referenz [1] mit plan-konvexer Mikrowellenlinse und flachem Mikrowellenspiegel;
- Fig. 3: eine schematische Querschnittsdarstellung eines NMR-MAS-Probenkopfs nach dem Stand der Technik gemäß Referenz [1] im Vergleich zur Erfindung nach Fig. 1;
- Fig. 4: eine schematische 3D-CAD-Ansicht eines erfindungsgemäß modifizierten Spulenklotzes;
- Fig. 5: einen Größenvergleich zwischen einem 1,3mm MAS-Stator (links) und einem 3,2mm MAS-Stator (rechts);
- Fig. 6: ein zentraler Schnitt durch die H-Feldamplitudenverteilung einer 3D EM-Simulation bei zwei Anordnungen nach dem Stand der Technik (links) und einer erfindungsgemäßen Anordnung (rechts oben), wobei die Skalierung der Feldwerte gleich gewählt wurde; und
- Fig. 7: eine Grafik mit experimentellen Ergebnissen der DNP-Verstärkung durch die erfindungsgemäße Anordnung im Vergleich zu Anordnungen nach dem Stand der Technik.

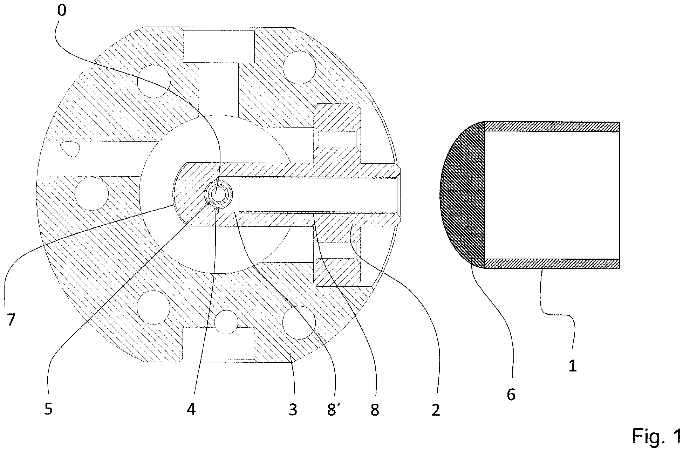

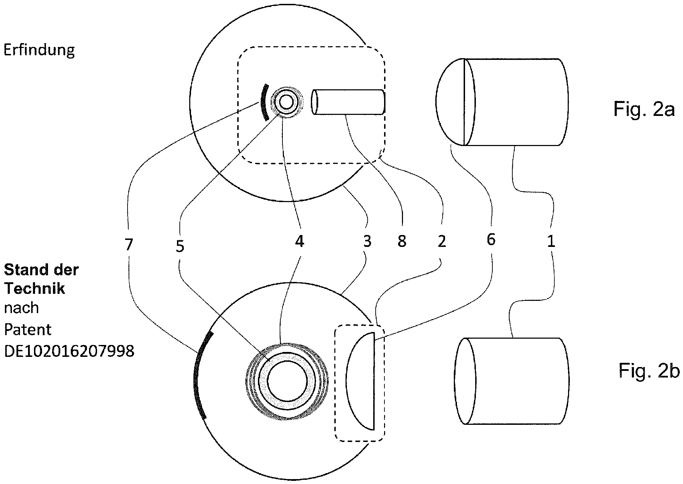

Die Erfindung betrifft eine neuartige Ausgestaltung eines Spulenklotzes für einen MAS-DNP-NMR-Probenkopf und findet ihre Hauptanwendung als Bestandteil einer Magnetresonanz-Apparatur. Die Ausführungsformen des erfindungsgemäßen Probenkopfes, wie sie etwa in den Figuren 1 und 2a dargestellt sind, umfassen jeweils einen NMR-MAS-Probenkopf mit einem **MAS-Stator 3** zur Aufnahme eines länglichen, von einer **HF-Spule 4** umgebenen **MAS-Rotors 5** mit einer Probensubstanz in einem **Probenvolumen 0,** und mit einem hohlen, länglichen **ersten Mikrowellenleiter 1** zur Zuführung von Mikrowellenstrahlung durch einen in eine Wand des MAS-Stators 3 eingeführten **Spulenklotz 2** hindurch in das Probenvolumen 0.

Die erfindungsgemäße Anordnung zeichnet sich dadurch aus, dass der Spulenklotz 2 aus dielektrischem Material aufgebaut ist, dass der Spulenklotz 2 geometrisch so ausgedehnt und in die Wand des MAS-Stators 3 derart eingeführt ist, dass er die HF-Spule 4 und den MAS-Rotor 5 zumindest teilweise umgibt, dass der Spulenklotz 2 eine **erste Bohrung 4'** aufweist, die koaxial zur Längsachse des länglichen MAS-Rotors 5 verläuft und an deren innerer Wandung die HF-Spule 4 befestigt ist, und dass der Spulenklotz 2 eine **zweite Bohrung 8'** aufweist, die koaxial zur Längsachse des ersten hohlen, länglichen Mikrowellenleiters 1 verläuft und die einen hohlen, länglichen **zweiten Mikrowellenleiter 8** zur Zuführung von Mikrowellenstrahlung aus dem ersten Mikrowellenleiter 1 in das Probenvolumen 0 umfasst.

Der Innendurchmesser des zweiten Mikrowellenleiters 8 ist kleiner als der Innendurchmesser des ersten Mikrowellenleiters 1, vorzugsweise um mindestens 50%.

Die zweite Bohrung 8' kann eine metallische Beschichtung ihrer Innenwandung aufweisen und dadurch als in den Spulenklotz 2 integrierter zweiter Mikrowellenleiter 8 wirken.

Die Innenwandung der ersten Bohrung 4' kann eine -in der vorliegenden Zeichnung nicht eigens dargestellt - Riffelung oder Nutenstruktur aufweisen, an welcher die HF-Spule 4 kraft- und/oder formschlüssig befestigt wird.

Auch kann das Spulenabgewandte Ende des rohrförmigen zweiten Mikrowellenleiters 8 eine, insbesondere trompetenartige, Aufweitung 8" aufweisen, wie sie in Fig. 4 zu erkennen ist.

Der erste Mikrowellenleiter 1 kann bei Ausführungsformen der Erfindung geometrisch, insbesondere hinsichtlich seines Durchmessers und seiner Form, derart aufgebaut sein, dass er die durch ihn geleitete Mikrowellenstrahlung auf die ihm zugewandte Öffnung des zweiten Mikrowellenleiters 8 im Spulenklotz 2 fokussiert.

Bei den in den Figuren 1, 2a und 6 dargestellten, dazu alternativen Ausführungsformen der Erfindung ist zwischen dem ersten Mikrowellenleiter 1 und dem Spulenklotz 2 am Spulenklotzseitigen freien Ende des ersten Mikrowellenleiters 1 eine **Mikrowellenlinse 6** zur Bündelung der zugeführten Mikrowellenstrahlung auf die Linsenseitige Öffnung des zweiten Mikrowellenleiters 8 angeordnet. Diese Mikrowellenlinse 6 ist auf der dem Probenvolumen 0 zugewandten Seite derart angeordnet und hinsichtlich ihrer Brennweite geometrisch so ausgebildet ist, dass die Linsenseitige Öffnung des zweiten Mikrowellenleiters 8 im Brennpunkt der Mikrowellenlinse 6 liegt.

Des Weiteren erkennt man bei den Ausführungsformen der Figuren 1, 2a und 6, dass auf der dem zweiten Mikrowellenleiter 8 bezüglich des MAS-Rotors 5 gegenüberliegenden Innenseite des MAS-Stators 3 ein **Mikrowellenspiegel 7** zur Reflexion der aus dem zweiten Mikrowellenleiter 8 austretenden und durch das Probenvolumen 0 hindurchtretenden Mikrowellenstrahlung vorhanden ist. Dieser Mikrowellenspiegel 7 kann am Spulenklotz 2 angebracht oder räumlich in den Spulenklotz 2 integriert sein. Er kann zylindrisch sowie in Richtung auf das Probenvolumen 0 konkav aufgebaut und konstruktiv derart ausgestaltet sein, dass er die vom Probenvolumen 0 kommend auf ihn auftreffende Mikrowellenstrahlung auf die Längsachse des MAS-Rotors 5 fokussiert.

Die dem zweiten Mikrowellenleiter 8 bezüglich der HF-Spule 4 gegenüberliegende Rückseite des Spulenklotzes 2 kann derart metallisch beschichtet oder mit einer Metallfolie versehen sein, dass sie als Mikrowellenspiegel 7 wirkt.

Während Fig. 1 in einer schematischen Schnittdarstellung durch eine horizontale Ebene viele Details des erfindungsgemäßen NMR-MAS-Probenkopfes sowie des erfindungsgemäß modifizierten Spulenklotzes 2 zeigt, veranschaulicht Fig. 2a in einer noch mehr schematisierten Prinzipzeichnung die erfindungsgemäße Anordnung im direkten Vergleich mit der in Fig. 2b dargestellten Anordnung nach dem nächstkommenden Stand der Technik gemäß Referenz [1]. Die erheblichen Unterschiede im Aufbau und der Ausgestaltung des jeweiligen Spulenklotzes 2 bedürfen wohl keiner weiteren Kommentierung. In den Figuren 2a und 2b wird dem Betrachter auch vor Augen gehalten, dass die Hauptanwendungen der vorliegenden Erfindung vor allem bei Systemen mit kleineren Außendurchmessern des MAS-Rotors 5 als beim herkömmlichen Stand der Technik liegen.

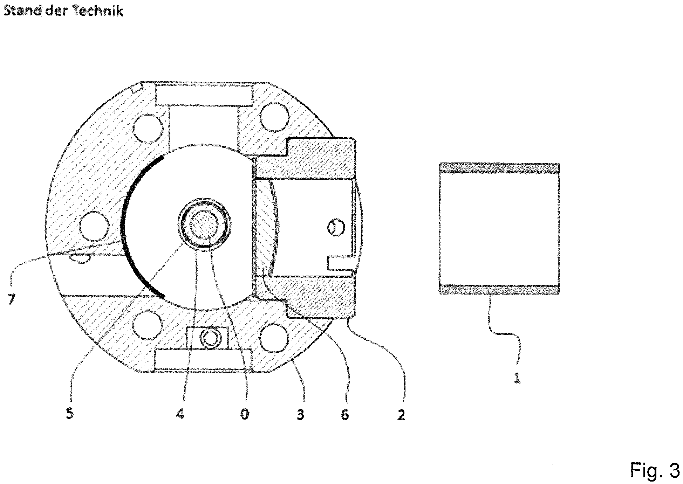

Fig. 3 stellt -als Pendant zur Darstellung der Erfindung in Fig. 1- einen NMR-MAS-Probenkopf mit Spulenklotz nach dem Stand der Technik dar, wie er in Referenz [1] beschrieben ist. Bei diesem nächstliegenden Stand der Technik werden ebenfalls eine Linse und ein Spiegel verwendet, allerdings eben *nicht* mit den oben beschriebenen erfindungsgemäßen Modifikationen, was vor allem an einer erheblich anderen Struktur und Positionierung des Spulenklotzes sowie insbesondere dem völligen Fehlen des in den Spulenklotz integrierten zweiten Mikrowellenleiters deutlich wird.

Die wesentlichen erfindungsgemäßen Modifikationen des Spulenklotzes 2 sind konzentriert in der teilweise transparenten räumlichen Darstellung der Fig. 4 zu erkennen:
Wesentlich für die vorliegende Erfindung ist ein -in der Zeichnung natürlich nicht darstellbarer- Aufbau des Spulenklotzes 2 aus einem elektrisch nicht-leitenden, dielektrischem Material sowie seine geometrische Anordnung innerhalb des MAS-Stators 3 derart, dass der Spulenklotz 2 die HF-Spule 4 in seiner ersten Bohrung 4' aufnimmt und damit auch den MAS-Rotor 5 umgibt. Die HF-Spule 4 ist dabei der inneren Wandung der ersten Bohrung 4' form- und/oder kraftschlüssig befestigt. Ganz erheblich für die Erfindung ist auch der in der zweiten Bohrung 8' des Spulenklotzes 2 angeordnete hohlen, längliche zweite Mikrowellenleiter 8.

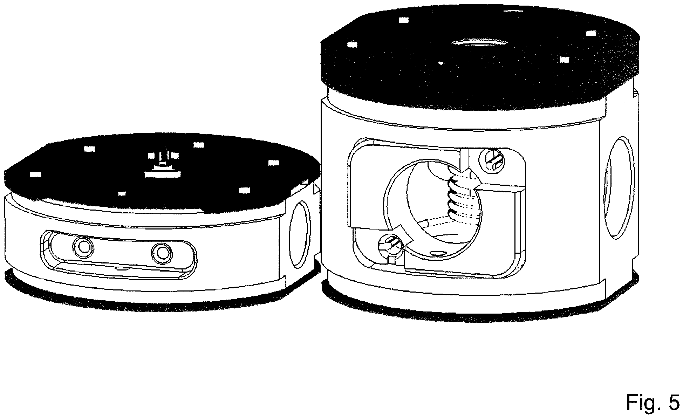

In Fig. 5 sind in einem direkten Größenvergleich ein 1,3mm-MAS-Stator (links) einem üblichen 3,2mm-MAS-Stator (rechts) gegenübergestellt. Man erkennt deutlich, welche -allein schon rein geometrischen- Schwierigkeiten beim Mikrowellen-Zugang zum Probenvolumen in der Anordnung mit den kleineren MAS-Rotoren auftreten. Diese verhinderten bisher eine effizientere Ausnutzung der eingestrahlten Mikrowellenleistung, was nun durch die vorliegende Erfindung entscheidend verbessert werden kann.

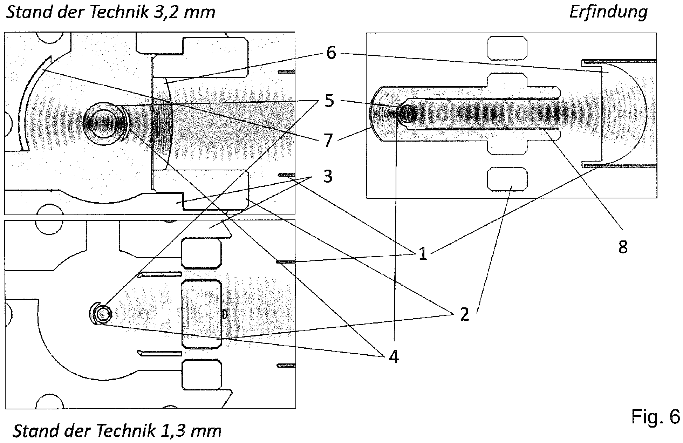

Fig. 6 stellt eine 3D EM-Simulation der H-Feld Amplitude in einer horizontalen Schnittebene bei einer Anordnung nach dem nächstliegenden Stand der Technik gemäß Referenz [1] in einer 3,2mm-Ausführung (links oben), weiterem Stand der Technik in einer 1,3mm-Ausführung (links unten) sowie einer erfindungsgemäßen Anordnung (rechts oben) dar. Damit wird der technische Fortschritt aufgrund der vorliegenden Erfindung deutlich veranschaulicht:

### Bisheriger Stand der Technik (links unten):

Der Gaußsche Strahl kommt von rechts und trifft auf Spule und Rotor; die Ausleuchtung ist zwar recht gut, aber nach dem ersten Auftreffen wird der Strahl unkontrolliert reflektiert und gebeugt, wodurch ein beträchtlicher Teil verloren geht.

### Nächstkommender Stand der Technik (links oben):

Der Gaußsche Strahl kommt von rechts, trifft auf die zylindrische Linse und wird in einer Richtung gebündelt, so dass er nahezu senkrecht auf den Rotor trifft.

Dadurch lässt sich die Rotorwand einheitlich anpassen, da der Rotor dann nicht wie eine gekrümmte Fläche wirkt, sondern wie ein planares Dielektrikum. Die Spule transmittiert den Strahl weitgehend ungehindert, so dass dieser am zylindrischen Spiegel reflektiert wird und erneut durch die Probe dringt. Durch den zweifachen Durchgang erhöht sich die aufgenommene Leistung in der Probe.

### Erfindung (rechts oben):

Aufgrund des erfindungsgemäß im Spulenklotz 2 angeordneten zweiten Mikrowellenleiters 8 sowie der erfindungsgemäßen Positionierung und Dimensionierung von Mikrowellenlinse 6 und Mikrowellenspiegel 7 wird eine nochmals ganz erheblich verbesserte Effizienz der eingestrahlten Mikrowellenleistung erzielt, was insbesondere bei Systemen mit MAS-Rotoren-Durchmessern « 3,2mm (hier: 1,3mm) in besonderem Maße zu Buche schlägt.

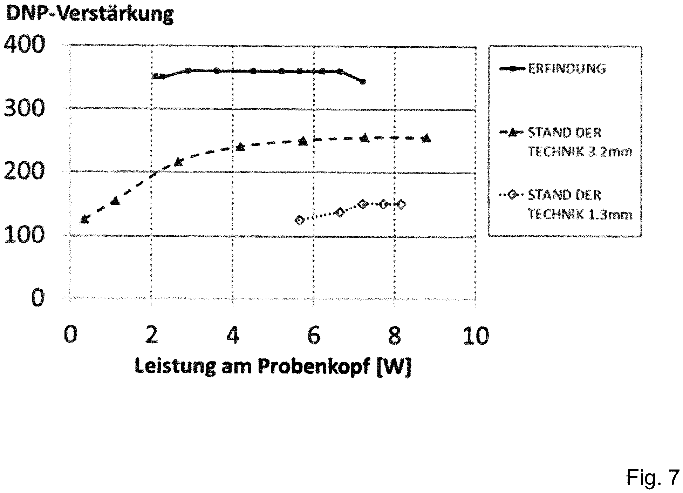

Der Effizienzgewinn aufgrund der Erfindung schließlich ist beispielhaft in Fig. 7 grafisch abgebildet. Dabei ist auf der Ordinatenachse die Größe der DNP-Verstärkung gegen die auf der Abszissenachse angegebene Leistung am Probenkopf in Watt aufgetragen.

Aus den in Fig. 7 zusammengestellten experimentellen Daten ist zu entnehmen, wie sich der erfindungsgemäß modifizierte Spulenklotz hinsichtlich des Polarisierungszugewinns (DNP gain) als Funktion der eingestrahlten Mikrowellenleistung verhält. Hier ist deutlich zu erkennen, dass bereits die (in Fig. 6 links oben gezeigte) Anordnung gemäß Referenz [1] bei einem 3,2mm-System den "DNP gain" verbessert. Die entsprechende mittlere Kurve (schwarze Dreieckssymbole) in Fig. 7 liegt schon ganz erheblich über der unteren Kurve (offene Rautensymbole), welche die Messergebnisse mit einer "herkömmlichen" (in Fig. 6 links unten gezeigte) Anordnung nach dem älteren Stand der Technik bei einem 1,3mm-System zeigt, wo die Lehre von Referenz [1] wegen der geometrischen Beschränkungen auf praktische Grenzen stößt.

Die Anordnung nach Referenz [1] führt bereits dazu, dass man den gleichen Polarisierungseffekt schon bei deutlich niedrigerer Mikrowellenleistung als bei einer Anordnung nach dem älteren Stand der Technik erhält. Als Folge kann man also auf kleinere und kostengünstigere Mikrowellenquellen zurückgreifen. Ist die bereitgestellte Leistung nicht begrenzt, so lässt sich damit in Sättigung unter Umständen auch ein höherer DNP gain erreichen.

Freilich liegen die Messwerte bei einer erfindungsgemäßen Anordnung (oberste Kurve mit schwarzen Quadratsymbolen) noch einmal weit über den mit der Anordnung nach Referenz [1] erzielbaren DNP-Verstärkungswerten. Hinzu kommt außerdem noch, dass bei der Messung dieser obersten Kurve ein erfindungsgemäß modifiziertes 1,3mm-System verwendet wurde, während die mittlere Kurve mit einem 3,2mm-System aufgenommen wurde.

### Bezugszeichenliste

- 0: Probenvolumen
- 1: erster Mikrowellenleiter
- 2: Spulenklotz
- 3: MAS-Stator
- 4: HF-Spule
- 4': erste Bohrung
- 5: MAS-Rotor
- 6: Mikrowellenlinse
- 7: Mikrowellenspiegel
- 8: zweiter Mikrowellenleiter
- 8': zweite Bohrung
- 8": trompetenartige Aufweitung

### Referenzliste:

Für die Beurteilung der Patentfähigkeit in Betracht gezogene Publikationen:
[1] DE 10 2016 207 998 B3
[2] Cryogenic sample exchange NMR probe for magic angle spinning dynamic nuclear polarization, A. Barnes et al., Journal of Magnetic Resonance 198 (2009) 261-270
[3] WO 2015/175507 A1
[4] US 2016/0334476 A1
[5] EP 3 030 917 B1
[6] US 2017/0074952 A1

## Patentansprüche

1. NMR-MAS-Probenkopf mit einem MAS-Stator (3) zur Aufnahme eines länglichen, von einer HF-Spule (4) umgebenen MAS-Rotors (5) mit einer Probensubstanz in einem Probenvolumen (0), und mit einem hohlen, länglichen ersten Mikrowellenleiter (1) zur Zuführung von Mikrowellenstrahlung durch einen in eine Wand des MAS-Stators (3) eingeführten Spulenklotz (2) hindurch in das Probenvolumen (0), **dadurch gekennzeichnet, dass** der Spulenklotz (2) nach einem der Ansprüche 11 bis 15 ausgestaltet ist, und geometrisch so ausgedehnt und in die Wand des MAS-Stators (3) derart eingeführt ist, dass er die HF-Spule (4) und den MAS-Rotor (5) zumindest teilweise umgibt.

2. NMR-MAS-Probenkopf nach Anspruch 1, **dadurch gekennzeichnet, dass** die erste Bohrung (4') des Spulenklotzes (2) zur Aufnahme eines MAS-Rotors (5) mit einem Durchmesser kleiner als 2mm, vorzugsweise einem Durchmesser von 0,4mm bis 1,9mm, insbesondere einem Durchmesser von etwa 1,3mm, dimensioniert ist.

3. NMR-MAS-Probenkopf nach Anspruch 1 oder 2, **dadurch gekennzeichnet, dass** der erste Mikrowellenleiter (1) geometrisch, insbesondere hinsichtlich seines Durchmessers und seiner Form, derart aufgebaut ist, dass er die durch ihn geleitete Mikrowellenstrahlung auf die ihm zugewandte Öffnung des zweiten Mikrowellenleiters (8) im Spulenklotz (2) fokussiert.

4. NMR-MAS-Probenkopf nach Anspruch 3, **dadurch gekennzeichnet, dass** der erste Mikrowellenleiter (1) auf seiner dem Probenvolumen (0) zugewandten Seite eine Querschnittsreduktion zur Fokussierung der Mikrowellenstrahlung aufweist.

5. NMR-MAS-Probenkopf nach Anspruch 3, **dadurch gekennzeichnet, dass** zwischen dem ersten Mikrowellenleiter (1) und dem Spulenklotz (2), vorzugsweise an dem Spulenklotzseitigen freien Ende des ersten Mikrowellenleiters (1), eine Mikrowellenlinse (6) zur Bündelung der zugeführten Mikrowellenstrahlung auf die Linsenseitige Öffnung des zweiten Mikrowellenleiters (8) angeordnet ist.

6. NMR-MAS-Probenkopf nach einem der vorhergehenden Ansprüche, **dadurch gekennzeichnet, dass** auf der dem zweiten Mikrowellenleiter (8) bezüglich des MAS-Rotors (5) gegenüberliegenden Innenseite des MAS-Stators (3) ein Mikrowellenspiegel (7) zur Reflexion der aus dem zweiten Mikrowellenleiter (8) austretenden und durch das Probenvolumen (0) hindurchtretenden Mikrowellenstrahlung vorhanden ist.

7. NMR-MAS-Probenkopf nach Anspruch 6, **dadurch gekennzeichnet, dass** der Mikrowellenspiegel (7) am Spulenklotz (2) angebracht oder räumlich in den Spulenklotz (2) integriert ist.

8. NMR-MAS-Probenkopf nach einem der Ansprüche 6 oder 7, **dadurch gekennzeichnet, dass** der Mikrowellenspiegel (7) zylindrisch sowie in Richtung auf das Probenvolumen (0) konkav aufgebaut ist,
und dass der Mikrowellenspiegel (7) konstruktiv derart ausgestaltet ist, dass er die vom Probenvolumen (0) kommend auf ihn auftreffende Mikrowellenstrahlung auf die Längsachse des MAS-Rotors (5) fokussiert.

9. NMR-MAS-Probenkopf nach einem der vorhergehenden Ansprüche, **dadurch gekennzeichnet, dass** die HF-Spule (4) eine aus mehreren voneinander beabstandeten Windungen aufgebaute einlagige Solenoidspule ist, deren Windungsdrahtdicke d und Windungsabstand D so optimiert sind, dass die Mikrowellenstrahlung durch die HF-Spule (4) zu mindestens 80% transmittiert wird.

10. NMR-MAS-Probenkopf nach Anspruch 9, **dadurch gekennzeichnet, dass** die HF-Spule (4) eine Windungsdrahtdicke 0,05mm ≤ d ≤ 0,30mm, sowie eine Steigung der Windungen zwischen 0,1mm und 1,0mm aufweist.

11. Spulenklotz (2) zur Verwendung in einem NMR-MAS-Probenkopf mit einem ersten Mikrowellenleiter, wobei der Spulenklotz (2) aus einem elektrisch nicht-leitenden dielektrischen Material aufgebaut ist und eine erste Bohrung (4') aufweist, welche dazu eingerichtet ist, im Betriebszustand des NMR-MAS-Probenkopfes einen MAS-Rotor (5) aufzunehmen, koaxial zum Rotor verlaufend, und welche eine innere Wandung aufweist, an der eine HF-Spule (4) zur Durchführung von NMR-Messungen an einer Probensubstanz, welche sich im Rotor des NMR-MAS-Probenkopfes befindet, befestigt ist,
und wobei der Spulenklotz (2) eine zweite Bohrung (8') aufweist, die einen hohlen, länglichen zweiten Mikrowellenleiter (8) umfasst, zur Weiterleitung von Mikrowellen aus dem ersten Mikrowellenleiter des NMR-MAS-Probenkopfes, und welche geometrisch so ausgebildet ist, dass sie koaxial zu einer Längsachse des ersten Mikrowellenleiters angeordnet werden kann.

12. Spulenklotz nach Anspruch 11, **dadurch gekennzeichnet, dass** der Innendurchmesser des zweiten Mikrowellenleiters (8) kleiner ist als der Innendurchmesser des ersten Mikrowellenleiters (1), vorzugsweise um mindestens 50%.

13. Spulenklotz nach einem der Ansprüche 11 oder 12, **dadurch gekennzeichnet, dass** die dem zweiten Mikrowellenleiter (8) bezüglich der HF-Spule (4) gegenüberliegende Rückseite des Spulenklotzes (2) derart metallisch beschichtet oder mit einer Metallfolie versehen ist, dass sie als Mikrowellenspiegel (7) wirkt.

14. Spulenklotz nach einem der Ansprüche 11 bis 13, **dadurch gekennzeichnet, dass** die zweite Bohrung (8') eine metallische Beschichtung ihrer Innenwandung aufweist und dadurch als in den Spulenklotz (2) integrierter zweiter Mikrowellenleiter (8) wirkt.

15. Spulenklotz nach einem der Ansprüche 11 bis 14, **dadurch gekennzeichnet, dass** die Innenwandung der ersten Bohrung (4') eine Riffelung oder Nutenstruktur aufweist, an welcher die HF-Spule (4) kraft- und/oder formschlüssig befestigt ist.

## Claims

1. An NMR-MAS probehead having an MAS stator (3) for receiving an elongate MAS rotor (5) that is surrounded by an RF coil (4), said MAS rotor having a sample substance in a sample volume (0), and having a hollow, elongate first microwave guide (1) for supplying microwave radiation into the sample volume (0) through a coil block (2) introduced in a wall of the MAS stator (3),
**characterized in that**
the coil block (2) is designed in accordance with any one of the claims 11 to 15 and has such a geometric extent and is inserted into the wall of the MAS stator (3) in such a way that it at least partly surrounds the RF coil (4) and the MAS rotor (5).

2. The NMR-MAS probehead as claimed in claim 1, **characterized in that** the first bore (4') of the coil block (2) is dimensioned so as to receive an MAS rotor (5) with a diameter of less than 2 mm, preferably a diameter of 0.4 mm to 1.9 mm, in particular a diameter of approximately 1.3 mm.

3. The NMR-MAS probehead as claimed in claim 1 or 2, **characterized in that** the first microwave guide (1), in particular in view of its diameter and its form, has such a geometric structure that it focuses the microwave radiation guided therethrough onto the opening, facing it, of the second microwave guide (8) in the coil block (2).

4. The NMR-MAS probehead as claimed in claim 3, **characterized in that** the first microwave guide (1), on its side facing the sample volume (0), has a reduction in cross section for focusing the microwave radiation.

5. The NMR-MAS probehead as claimed in claim 3, **characterized in that** a microwave lens (6) for focusing the supplied microwave radiation onto the lens-side opening of the second microwave guide (8) is arranged between the first microwave guide (1) and the coil block (2), preferably at the coil-block-side free end of the first microwave guide (1).

6. The NMR-MAS probehead as claimed in any one of the preceding claims, **characterized in that** a microwave mirror (7) for reflecting the microwave radiation that emerges from the second microwave guide (8) and passes through the sample volume (0) is present on the inner side of the MAS stator (3) that lies opposite the second microwave guide (8) in respect of the MAS rotor (5).

7. The NMR-MAS probehead as claimed in claim 6, **characterized in that** the microwave mirror (7) is attached to the coil block (2) or spatially integrated into the coil block (2).

8. The NMR-MAS probehead as claimed in either of claims 6 and 7, **characterized in that** the microwave mirror (7) is constructed to be cylindrical and concave in the direction of the sample volume (0) and the microwave mirror (7) has such a structural configuration that it focuses the microwave radiation that comes from the sample volume (0) and that is incident thereon onto the longitudinal axis of the MAS rotor (5).

9. The NMR-MAS probehead as claimed in any one of the preceding claims, **characterized in that** the RF coil (4) is a single-layer solenoid coil constructed from a plurality of spaced apart turns, the winding thickness d and turn spacing D of which are optimized in such a way that at least 80% of the microwave radiation is transmitted through the RF coil (4).

10. The NMR-MAS probehead as claimed in claim 9, **characterized in that** the RF coil (4) has a winding thickness of 0.05 mm ≤ d ≤ 0.30 mm and a pitch of the turns of between 0.1 mm and 1.0 mm.

11. A coil block (2) for use in an NMR-MAS probehead comprising a first microwave guide, wherein the coil block (2) is constructed from an electrically non-conducting dielectric material and comprises a first bore (4') which is designed, in the operating state of the NMR-MAS probehead, to receive an MAS rotor (5) which extends coaxially with the rotor, and which comprises an inner wall to which an RF coil (4) is mounted for performing NMR measurements on a sample substance which is located in the rotor of the NMR-MAS probehead,
and wherein the coil block (2) comprises a second bore (8') which comprises a hollow elongate second microwave guide (8) for supplying microwaves from the first microwave guide of the NMR-MAS probehead, and which is geometrically configured such that it can be arranged coaxially with a longitudinal axis of the first microwave guide.

12. The coil block as claimed in claim 11, **characterized in that** the internal diameter of the second microwave guide (8) is smaller than the internal diameter of the first microwave guide (1), preferably by at least 50%.

13. The coil block as claimed in either of claims 11 and 12, **characterized in that** the backside of the coil block (2) that lies opposite the second microwave guide (8) in respect of the RF coil (4) has such metallic coating or is provided with a metal film in such a way that it acts as a microwave mirror (7).

14. The coil block as claimed in any one of claims 11 to 13, **characterized in that** the second bore (8') has a metallic coating on its inner wall and thus acts as a second microwave guide (8) that is integrated into the coil block (2).

15. The coil block as claimed in any one of claims 11 to 14, **characterized in that** the inner wall of the first bore (4') has a corrugation or groove structure, on which the RF coil (4) is fastened in force-fit and/or interlocking fashion.

## Revendications

1. Tête de sonde RMN-MAS comprenant un stator MAS (3), qui est destiné à recevoir un rotor MAS (5) allongé, entouré d'une bobine HF (4) et pourvu d'une substance échantillon dans un volume d'échantillon (0), et un premier guide d'ondes hyperfréquences (1) creux et allongé qui est destiné à amener un rayonnement hyperfréquence à travers un bloc formant bobine (2), inséré dans une paroi du stator MAS (3), jusque dans le volume d'échantillon (0), **caractérisée en ce que** le bloc formant bobine (2) selon l'une des revendications 11 à 15 est étendu géométriquement et inséré dans la paroi du stator MAS (3) de façon à entourer au moins partiellement la bobine HF (4) et le rotor MAS (5).

2. Tête de sonde RMN-MAS selon la revendication 1, **caractérisée en ce que** le premier alésage (4') du bloc formant bobine (2) est dimensionné pour recevoir un rotor MAS (5) d'un diamètre inférieur à 2 mm, de préférence d'un diamètre de 0,4 mm à 1,9 mm, en particulier d'un diamètre d'environ 1,3 mm.

3. Tête de sonde RMN-MAS selon la revendication 1 ou 2, **caractérisée en ce que** le premier guide d'ondes hyperfréquences (1) est conçu géométriquement, notamment en ce qui concerne son diamètre et sa forme, de manière à focaliser le rayonnement hyperfréquence, guidé à travers lui, sur l'ouverture, dirigée vers lui, du deuxième guide d'ondes hyperfréquences (8) du bloc formant bobine (2).

4. Tête de sonde RMN-MAS selon la revendication 3, **caractérisée en ce que** le premier guide d'ondes hyperfréquences (1) présente sur son côté tourné vers le volume d'échantillon (0) une réduction de section transversale pour focaliser le rayonnement hyperfréquence.

5. Tête de sonde RMN-MAS selon la revendication 3, **caractérisée en ce qu'**une lentille à ondes hyperfréquences (6) est disposée entre le premier guide d'ondes hyperfréquences (1) et le bloc formant bobine (2), de préférence à l'extrémité libre, côté bloc formant bobine, du premier guide d'ondes hyperfréquences (1), pour concentrer le rayonnement hyperfréquence sur l'ouverture, côté lentille, du deuxième guide d'ondes hyperfréquences (8).

6. Tête de sonde RMN-MAS selon l'une des revendications précédentes, **caractérisée en ce qu'**un miroir à ondes hyperfréquences (7) est prévu sur le côté intérieur du stator MAS (3), opposé au deuxième guide d'ondes hyperfréquences (8) par rapport au rotor MAS (5), pour réfléchir le rayonnement hyperfréquence sortant du deuxième guide d'ondes hyperfréquences (8) et traversant le volume d'échantillon (0).

7. Tête de sonde RMN-MAS selon la revendication 6, **caractérisée en ce que** le miroir à ondes hyperfréquences (7) est monté sur le bloc formant bobine (2) ou est intégré spatialement dans le bloc formant bobine (2).

8. Tête de sonde RMN-MAS selon l'une des revendications 6 et 7, **caractérisée en ce que** le miroir à ondes hyperfréquences (7) est conçu pour être cylindrique et concave en direction du volume d'échantillon (0),
et **en ce que** le miroir à ondes hyperfréquences (7) a une construction telle qu'il focalise le rayonnement hyperfréquence, qui provient du volume d'échantillon (0) et qui lui est incident, sur l'axe longitudinal du rotor MAS (5).

9. Tête de sonde RMN-MAS selon l'une des revendications précédentes, **caractérisée en ce que** la bobine HF (4) est une bobine de solénoïde monocouche composée de plusieurs enroulements qui sont espacés les uns des autres et dont l'épaisseur d des fils d'enroulement et l'espacement D des enroulements sont optimisés de manière à ce que le rayonnement hyperfréquence soit transmis à au moins 80 % à travers la bobine HF (4).

10. Tête de sonde RMN-MAS selon la revendication 9, **caractérisée en ce que** la bobine HF (4) a une épaisseur de fil d'enroulement 0,05 mm ≤ d ≤ 0,30 mm et un pas d'enroulements compris entre 0,1 mm et 1,0 mm.

11. Bloc formant bobine (2) destiné à être utilisé dans une tête de sonde RMN-MAS comprenant un premier guide d'ondes hyperfréquences, le bloc formant bobine (2) étant construit à partir d'un matériau diélectrique électriquement non conducteur et comportant un premier alésage (4') qui est conçu pour recevoir un rotor MAS (5) dans l'état de fonctionnement de la tête de sonde RMN-MAS, en s'étendant coaxialement au rotor, et qui comporte une paroi intérieure à laquelle est fixée une bobine HF (4) destinée à effectuer des mesures RMN sur une substance échantillon située dans le rotor de la tête de sonde RMN-MAS,
et le bloc formant bobine (2) comportant un deuxième alésage (8') qui comprend un deuxième guide d'ondes hyperfréquences (8), creux et allongé, destiné à la transmission d'ondes hyperfréquences provenant du premier guide d'ondes hyperfréquences de la tête de sonde RMN-MAS et qui est conçu géométriquement de manière à pouvoir être disposé coaxialement à un axe longitudinal du premier guide d'ondes hyperfréquences.

12. Bloc formant bobine selon la revendication 11, **caractérisé en ce que** le diamètre intérieur du deuxième guide d'ondes hyperfréquences (8) est inférieur, de préférence d'au moins 50 %, au diamètre intérieur du premier guide d'ondes hyperfréquences (1).

13. Bloc formant bobine selon l'une des revendications 11 et 12, **caractérisé en ce que** le côté arrière du bloc formant bobine (2), qui est opposé au deuxième guide d'ondes hyperfréquences (8) par rapport à la bobine HF (4), est pourvu d'un revêtement métallique ou d'une feuille métallique et **en ce que** ledit côté arrière fonctionne également comme un miroir à ondes hyperfréquences (7).

14. Bloc formant bobine selon l'une des revendications 11 à 13, **caractérisé en ce que** le deuxième alésage (8') comporte un revêtement métallique sur sa paroi intérieure et fonctionne ainsi comme un deuxième guide d'ondes hyperfréquences (8) intégré dans le bloc formant bobine (2) .

15. Bloc formant bobine selon l'une des revendications 11 à 14, **caractérisé en ce que** la paroi intérieure du premier alésage (4') comporte une structure cannelée ou rainurée à laquelle la bobine HF (4) est fixée par une liaison en force et/ou à complémentarité de formes.
